# EUROPEAN PATENT APPLICATION

(11) **EP 4 618 730 A1**
(43) Date of publication of application: **17.09.2025**
(21) Application number: 25162038.1
(22) Date of filing: 06.03.2025
(51) Int. Cl.: H10K 71/80, H10K 77/10, H10K 59/80, H10K 71/00

(54) **PANEL SUBSTRATE AND METHOD OF MANUFACTURING DISPLAY MODULE USING THE SAME**

(30) Priority: 06.03.2024 KR 20240031675
(71) Applicant: Samsung Display Co., Ltd., Gyeonggi-Do (KR)
(72) Inventor: KWON, Ohjune, Yongin-si (KR); KIM, Sooyoun, Yongin-si (KR); OH, Soomin, Yongin-si (KR); LEE, Byeongjun, Yongin-si (KR)
(74) Representative: Marks & Clerk LLP

(57) **Abstract**

A panel substrate includes a mother substrate having a plurality of cell regions and a peripheral region surrounding the plurality of cell regions. A protective layer is disposed under the mother substrate. The protective layer includes a plurality of main parts overlapping the plurality of cell regions, and a plurality of bridge patterns overlapping the peripheral region. The plurality of bridge patterns connect main parts adjacent to each other among the plurality of main parts.

## Description

### 1. TECHNICAL FIELD

The present disclosure herein relates to a panel substrate and a method of manufacturing a display module using the same, and more particularly, to a panel substrate with increased reliability and a method of manufacturing a display module using the same.

### 2. DISCUSION OF RELATED ART

Various types of electronic apparatuses include a display device that generates an image to a user through a display screen. Examples of such electronic apparatuses include smart phones, digital cameras, laptop computers, navigation systems, and smart televisions.

The display device may include a display panel for displaying images. A protective layer may protect the display panel from the external environment by preventing a deformation of the display panel due to an external impact, and dissipating heat generated in the display panel. The protective layer may include a plurality of functional layers that are stacked to provide various functions for protecting the display panel. However, research is being conducted on an electronic apparatus that has a single-layer protective layer having various functions for protecting the display panel, and a method of manufacturing the same.

### SUMMARY

The present disclosure provides a panel substrate with increased reliability, and a method of manufacturing a display module using the same.

According to an embodiment of the present inventive concept, a panel substrate includes a mother substrate having a plurality of cell regions and a peripheral region surrounding the plurality of cell regions. A protective layer is disposed under the mother substrate. The protective layer includes a plurality of main parts overlapping the plurality of cell regions, and a plurality of bridge patterns overlapping the peripheral region. The plurality of bridge patterns connect main parts adjacent to each other among the plurality of main parts.

In an embodiment, the main parts may include a first main part, a second main part spaced apart from the first main part in a first direction, and a third main part spaced apart from the first main part in a second direction crossing the first direction.

In an embodiment, the bridge patterns may include a first bridge pattern connecting the first main part and the second main part to each other, and a second bridge pattern connecting the first main part and the third main part to each other.

In an embodiment, the first bridge pattern includes a plurality of first bridge patterns and the second bridge pattern includes a plurality of second bridge patterns.

In an embodiment, the plurality of first bridge patterns may extend in the first direction and may be arranged in the second direction, and the plurality of second bridge patterns may extend in the second direction and may be arranged in the first direction.

In an embodiment, a shape of the first bridge pattern and a shape of the second bridge pattern may be different from each other.

In an embodiment, the first bridge pattern may have a zigzag shape extending in the second direction in a plan view.

In an embodiment, the second bridge pattern may include a first portion and a second portion extending from the first portion. A first width of the first portion in the first direction may be different from a second width of the second portion in the first direction.

In an embodiment, the plurality of main parts may further include a fourth main part spaced apart from the first main part in a direction opposite to the first direction, and a fifth main part spaced apart from the first main part in a direction opposite to the second direction.

In an embodiment, the bridge patterns may further include a third bridge pattern connecting the first main part and the fourth main part to each other, and a fourth bridge pattern connecting the first main part and the fifth main part to each other.

In an embodiment, the first main part and the second main part are spaced apart from each other by a first distance. The first main part and the third main part are spaced apart from each other by a second distance. The first distance and the second distance are equal to each other.

In an embodiment, each of the plurality of main parts may have a quadrangular shape in a plan view, and the bridge patterns may each connect one surface of one main part among the plurality of main parts to one surface of a main part of the plurality of main parts adjacent to the one main part.

In an embodiment, each of the plurality of main parts may have a same shape and size as each other in the plan view.

In an embodiment, a number of the plurality of bridge patterns disposed in a central region of the protective layer may be greater than a number of the plurality of bridge patterns disposed in an outer region of the protective layer that surrounds the central region.

In an embodiment, the plurality of main parts may have a different thickness in a vertical direction than a thickness of the plurality of bridge patterns in the vertical direction.

In an embodiment, each bridge pattern of the plurality of bridge patterns may extend from a respective main part of the plurality of main parts.

According to an embodiment of the present inventive concept, a method of manufacturing a display module includes providing a mother substrate having a plurality of cell regions and a peripheral region surrounding the plurality of cell regions. A protective layer is formed on the mother substrate to form a panel substrate. The panel substrate is cut to form the display module. The protective layer includes a plurality of main parts overlapping the plurality of cell regions, and a plurality of bridge patterns overlapping the peripheral region and connecting main parts adjacent to each other among the plurality of main parts.

In an embodiment, the forming of the protective layer may include applying a resin composition onto a top surface of the mother substrate to form a preliminary protective layer, and curing the preliminary protective layer.

In an embodiment, in the forming of the preliminary protective layer, the applying of the resin composition may be performed through a screen-printing process or a slit-coating process.

In an embodiment, the cutting of the panel substrate may include performing a first cutting that cuts the panel substrate along a first cutting line overlapping the peripheral region to form a plurality of sub-panel substrates, and performing a second cutting that cuts the plurality of sub-panel substrates along a second cutting line corresponding to the plurality of cell regions.

In an embodiment, the method of manufacturing a display module may further include transferring the panel substrate after the forming of the panel substrate.

In an embodiment, the mother substrate may include a preliminary base layer, a preliminary circuit layer disposed on the preliminary base layer, and a preliminary light-emitting element layer disposed on the preliminary circuit layer.

According to an embodiment of the present inventive concept, a method of manufacturing a display module includes providing a mother substrate. A protective layer is formed directly on the mother substrate to form a panel substrate. The protective layer includes a plurality of main parts, and a plurality of bridge patterns connecting main parts adjacent to each other among the plurality of main parts. The panel substrate is transferred. The plurality of bridge patterns increases a tensile force in a central region of the mother substrate during the transfer of the panel substrate to reduce sagging of the mother substrate. The panel substrate is cut to form the display module after transferring the panel substrate.

In an embodiment, the protective layer may be provided in a single-layer form and may be composed of a cured resin composition.

In an embodiment, at least some of the plurality of bridge patterns may have shapes that are different from each other in a plan view. The shapes of the plurality of bridge patterns may include at least two of a line shape, an X-shape, a zigzag shape or an L-shape in the plan view.

In an embodiment, a number of the plurality of bridge patterns disposed in the central region of the protective layer may be greater than a number of the plurality of bridge patterns disposed in an outer region of the protective layer that surrounds the central region.

At least some of the above and other features of the invention are set out in the claims.

### BRIEF DESCRIPTION OF THE DRAWINGS

The accompanying drawings are included to provide a further understanding of the present inventive concept, and are incorporated in and constitute a part of this specification. The drawings illustrate non-limiting embodiments of the present inventive concept. In the drawings:
FIG. 1 is a perspective view of an electronic apparatus according to an embodiment of the present inventive concept;
FIG. 2 is an exploded perspective view of an electronic apparatus according to an embodiment of the present inventive concept;
FIG. 3 is a cross-sectional view of a display panel according to an embodiment of the present inventive concept;
FIG. 4A is a plan view of a display module according to an embodiment of the present inventive concept;
FIG. 4B is a rear view of a display module according to an embodiment of the present inventive concept;
FIGS. 5A and 5B are cross-sectional views illustrating a partial configuration of an electronic apparatus according to embodiments of the present inventive concept;
FIG. 6A is a flowchart illustrating a method of manufacturing a display module according to an embodiment of the present inventive concept;
FIG. 6B is a flowchart illustrating some steps of a method of manufacturing a display module according to an embodiment of the present inventive concept;
FIGS. 7A to 10B illustrate some steps of a method of manufacturing a display module according to embodiments of the present inventive concept; and
FIGS. 11A to 11D are plan views illustrating a panel substrate according to embodiments of the present inventive concept.

### DETAILED DESCRIPTION OF EMBODIMENTS

The present inventive concept may be implemented in various modifications and have various forms, and non-limiting embodiments are illustrated in the drawings and described in detail in the text. It is to be understood, however, that embodiments of the present inventive concept are not intended to be limited to the particular forms disclosed, but on the contrary, are intended to cover all modifications, equivalents, and alternatives falling within the scope of the present inventive concept.

In this specification, it will be understood that when an element (or region, layer, portion, etc.) is referred to as being "on", "connected to" or "coupled to" another element or layer, it can be directly disposed on/connected to/coupled to the other element or intervening elements may be present. When an element (or region, layer, portion, etc.) is referred to as being "directly on", "directly connected to" or "directly coupled to" another element or layer, no intervening elements may be present.

Like reference numerals or symbols refer to like elements throughout the specification. In addition, in terms of drawings, the thickness and the ratio and the dimension of the element may be exaggerated for effective description of the technical contents.

As used herein, the term "and/or" includes any and all combinations of one or more of the associated listed items.

Terms such as first and second may be used to describe various components, but the components should not be limited by the terms. These terms are only used for the purpose of distinguishing one component from other components. For example, without departing from the scope of embodiments of the present inventive concept, a first component may be referred to as a second component, and similarly, a second component may be referred to as a first component. Singular expressions include plural expressions unless the context clearly indicates otherwise.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms "includes" and/or "including", when used in this specification, specify the presence of stated features, integers, steps, operations, elements, and/or components, but do not preclude the presence or addition of one or more other features, integers, steps, operations, elements, components, and/or groups thereof.

Hereinafter, embodiments of the present inventive concept will be described with reference to the accompanying drawings.

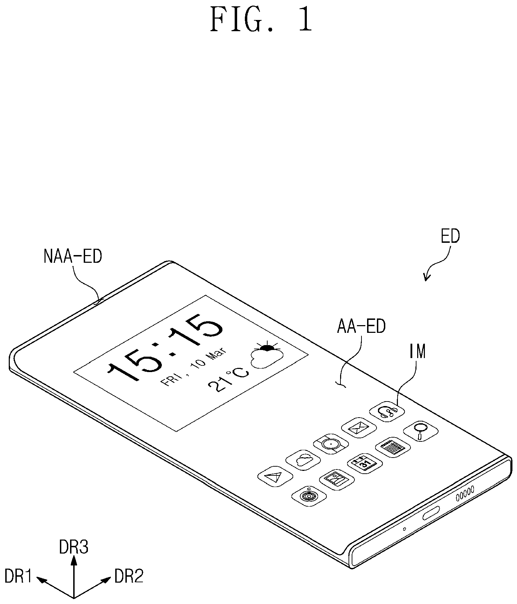

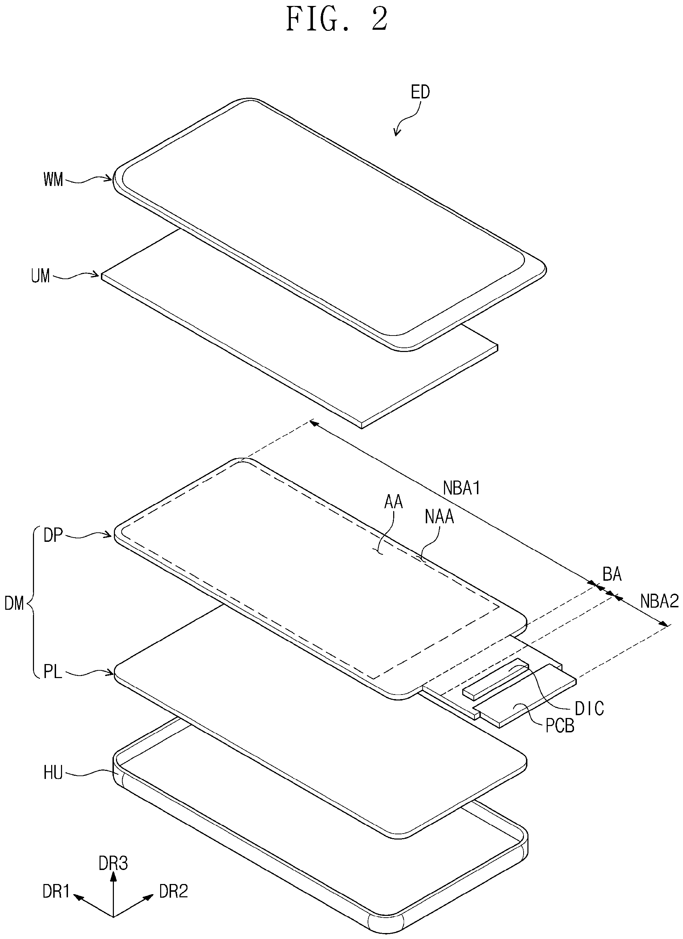

FIG. 1 is a perspective view of an electronic apparatus according to an embodiment of the present inventive concept. FIG. 2 is an exploded perspective view of an electronic apparatus according to an embodiment of the present inventive concept.

Referring to FIGS. 1 and 2, an electronic apparatus ED may be activated in response to an electrical signal. For example, in an embodiment the electronic apparatus ED may be a mobile phone, a tablet PC, a car navigation system, a game console, or a wearable device. However, embodiments of the present inventive concept are not necessarily limited thereto. In FIG. 1, the electronic apparatus ED is illustrated as a mobile phone for economy of description.

The electronic apparatus ED may display an image IM through an active region AA-ED. In an embodiment, the active region AA-ED may include a flat surface defined by a first direction DR1 and a second direction DR2. The active region AA-ED may further include a curved surface which is bent from at least one side of the flat surface defined by the first direction DR1 and the second direction DR2. It is illustrated that the electronic apparatus ED according to an embodiment, illustrated in FIG. 1, has two curved surfaces respectively bent from both side surfaces of the flat surface defined by the first direction DR1 and the second direction DR2. However, a shape of the active region AA-ED is not necessarily limited thereto. For example, the active region AA-ED may include the flat surface only, or the active region AA-ED may further include four curved surfaces which are respectively bent from at least two or more, for example, four sides of the flat surface.

In FIG. 1 and the subsequent drawings, first to third directions DR1 to DR3 are illustrated. The directions which are respectively indicated by the first direction DR1, the second direction DR2, and the third direction DR3, described in this specification, may have a relative concept and may thus be changed to other directions.

In an embodiment, the first direction DR1 and the second direction DR2 may be perpendicular to each other, and the third direction DR3 may be a normal direction of a plane defined by the first direction DR1 and the second direction DR2. However, embodiments of the present inventive concept are not necessarily limited thereto and the first to third directions DR1 to DR3 may cross each other at various different angles. In this specification, the wording "on a plane" may mean "when viewed on the plane defined by the first direction DR1 and the second direction DR2," and a thickness direction may mean the third direction DR3 which is the normal direction of the plane defined by the first direction DR1 and the second direction DR2.

The electronic apparatus ED may include an active region AA-ED and a peripheral region NAA-ED adjacent to the active region AA-ED (e.g., in the first and/or second directions DR1, DR2). The active region AA-ED may correspond to an active region AA of a display panel DP to be described later, and the peripheral region NAA-ED may correspond to a peripheral region NAA of the display panel DP.

The peripheral region NAA-ED may be a region that blocks a light signal and that is disposed outside the active region AA-ED and surrounds the active region AA-ED (e.g., in the first and/or second directions DR1, DR2). In an embodiment, the peripheral region NAA-ED may not be disposed on a front surface of the electronic apparatus ED and may only be disposed on a side surface of the electronic apparatus ED. In an embodiment, the peripheral region NAA-ED may be omitted.

The electronic apparatus ED according to an embodiment of the present inventive concept may include a window WM, an upper member UM, a display module DM, and a housing HU. In an embodiment, the electronic apparatus ED according to the present inventive concept may further include an electronic module accommodated in the housing HU. The electronic module may be an electronic component which outputs or receives a light signal. For example, in an embodiment the electronic module may include a camera module and a sensor module.

The window WM may provide an outer surface of the electronic apparatus ED. The window WM may cover a front surface of the display panel DP, and protect the display panel DP from external impacts and scratches. In an embodiment, the window WM may be coupled to the upper member UM through an adhesive layer.

The window WM may include an optically transparent insulating material. For example, the window WM may include a glass film or a synthetic resin film as a base film. The window WM may have a single- or multi-layered structure. For example, the window WM may include a plurality of plastic films coupled by an adhesive, or may include a glass film and a plastic film coupled by an adhesive. The window WM may further include a functional layer such as an anti-fingerprint layer, a phase control layer, and a hard coating layer which are disposed on a transparent film. However, embodiments of the present inventive concept are not necessarily limited thereto. For example, the functional layer(s) included in the window WM may vary.

The upper member UM may be disposed between the window WM and the display module DM (e.g., in the third direction DR3). In an embodiment, the upper member UM may include an anti-reflection layer and an input detection sensor. The anti-reflection layer may reduce external light reflectance. The input detection sensor may sense an external input of a user. The upper member UM may further include an adhesive layer which couples the anti-reflection layer and the input detection sensor to each other.

The display module DM may be disposed under the upper member UM (e.g., in a direction opposite to the third direction DR3). In an embodiment, the display module DM may include the display panel DP and a protective layer PL disposed under the display panel DP (e.g., in a direction opposite to the third direction DR3).

The display panel DP may include an active region AA in which the image IM is displayed, and a peripheral region NAA adjacent to the active region AA (e.g., in the first and/or second directions DR1, DR2). For example, a front surface of the display panel DP may include the active region AA and the peripheral region NAA. The active region AA may be a region that is activated in response to an electrical signal, and thus generates the image IM displayed in the active region AA-ED of the electronic apparatus ED.

The peripheral region NAA may be adjacent to the active region AA. The peripheral region NAA may surround the active region AA (e.g., in the first and/or second directions DR1, DR2). A driving circuit or a driving wire for driving the active region AA, various signal lines or pads for providing an electrical signal to the active region AA, an electronic element, or the like may be disposed in the peripheral region NAA.

The display panel DP may include a first non-bending region NBA1, a second non-bending region NBA2, and a bending region BA defined between the first non-bending region NBA1 and the second non-bending region NBA2 (e.g., in the first direction DR1). The bending region BA may be defined as a portion that is bendable with respect to a predetermined axis extending in the second direction DR2. When the bending region BA of the display panel DP is bent, the second non-bending region NBA2 of the display panel DP of may be disposed under the first non-bending region NBA1 of the display panel DP of (e.g., in a direction opposite to the third direction DR3).

The first non-bending region NBA1 of the display panel DP may include the active region AA containing pixels. A region of the first non-bending region NBA1 other than the active region AA may correspond to the peripheral region NAA.

A driving chip DIC for driving the display panel DP may be mounted on the second non-bending region NBA2 of the display panel DP. The display panel DP may include a plurality of display pads disposed adjacent to the end of the second non-bending region NBA2. A circuit board PCB may be disposed in the end portion of the second non-bending region NBA2 of the display panel DP. The plurality of display pads may be connected to the circuit board PCB in the second non-bending region NBA2. However, an embodiment of the present inventive concept is not necessarily limited thereto, and the driving chip DIC may be mounted on the circuit board PCB in some embodiments.

The circuit board PCB may overlap the second non-bending region NBA2. The circuit board PCB may transmit a signal for controlling the image IM or a power signal to the display panel DP from a main board inside the electronic apparatus ED. In an embodiment, the circuit board PCB may be a flexible printed circuit board. The circuit board PCB may include a circuit pad disposed adjacent to the end thereof. The circuit pad may be connected to a display pad. Accordingly, the circuit board PCB may be electrically connected to the display panel DP.

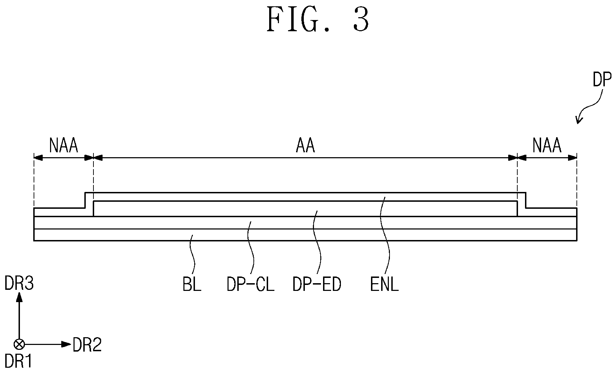

In an embodiment, the display panel DP may include a light-emitting element layer DP-ED (see FIG. 3) including an organic light-emitting element, a quantum dot light-emitting element, a micro LED light-emitting element, a nano LED light-emitting element, or the like. The light-emitting element layer DP-ED (see FIG. 3) may be a component substantially generating an image.

The protective layer PL may be disposed under the display panel DP (e.g., in a direction opposite to the third direction DR3). In an embodiment, the protective layer PL may be a member which supports the display panel DP, absorbs an impact applied to the display panel DP, and performs a heat-dissipating function for dissipating heat generated from components, for example, an electronic module EM, disposed under the display panel DP.

The housing HU may be disposed under the display module DM. In an embodiment, the housing HU may be coupled to the window WM. For example, the housing HU may be coupled to the window WM to provide a predetermined internal space. The display module DM and the upper member UM may be accommodated in the internal space of the housing HU.

The housing HU may include a material having a relatively high rigidity. For example, in an embodiment the housing HU may include glass, plastic, or metal, or a plurality of frames and/or plates composed of a combination thereof. The housing HU may stably protect components of the electronic apparatus ED, which are accommodated in the internal space, from an external impact.

FIG. 3 is a cross-sectional view of a display panel according to an embodiment of the present inventive concept.

Referring to FIG. 3, in an embodiment a display panel DP may include a base layer BL, a circuit layer DP-CL disposed on the base layer BL, a light-emitting element layer DP-ED, and an encapsulation layer ENL.

In an embodiment, the base layer BL may include a plastic substrate, a glass substrate, a metal substrate, or an organic/inorganic composite material substrate, or the like. For example, the base layer BL may include at least one polyimide layer. The aforementioned protective layer PL may be disposed under the base layer BL (e.g., in a direction opposite to the third direction DR3).

In an embodiment, the circuit layer DP-CL may include at least one insulating layer, semiconductor patterns, and conductive patterns. The insulating layer may include at least one inorganic layer and at least one organic layer. The semiconductor patterns and the conductive patterns may constitute signal lines, a pixel driving circuit, and a scan driving circuit. In addition, the circuit layer DP-CL may include a back metal layer.

In an embodiment, the light-emitting element layer DP-ED may include a display element, for example, a light-emitting element. For example, the light-emitting element may be an organic light-emitting element, a quantum dot light-emitting element, a micro LED light-emitting element, or a nano LED light-emitting element. The light-emitting element layer DP-ED may further include an organic layer such as a pixel-defining film.

The light-emitting element layer DP-ED may be disposed in an active region AA. Since a peripheral region NAA is disposed outside the active region AA and surrounds the active region AA (e.g., in the first and/or second directions DR1, DR2), the light-emitting element may not be disposed in the peripheral region NAA.

The encapsulation layer ENL may be disposed on the light-emitting element layer DP-ED (e.g., disposed directly thereon) and may cover the light-emitting element layer DP-ED. The encapsulation layer ENL may be disposed on the circuit layer DP-CL so as to seal the light-emitting element layer DP-ED. In an embodiment, the encapsulation layer ENL may be a thin-film encapsulation layer including a plurality of organic thin films and inorganic thin films. For example, the encapsulation layer ENL may include a thin-film encapsulation layer having a stacked structure of inorganic layer/organic layer/inorganic layer. However, embodiments of the present inventive concept are not necessarily limited thereto and the composition and arrangement of the layers of the stacked structure of the encapsulation layer ENL may vary.

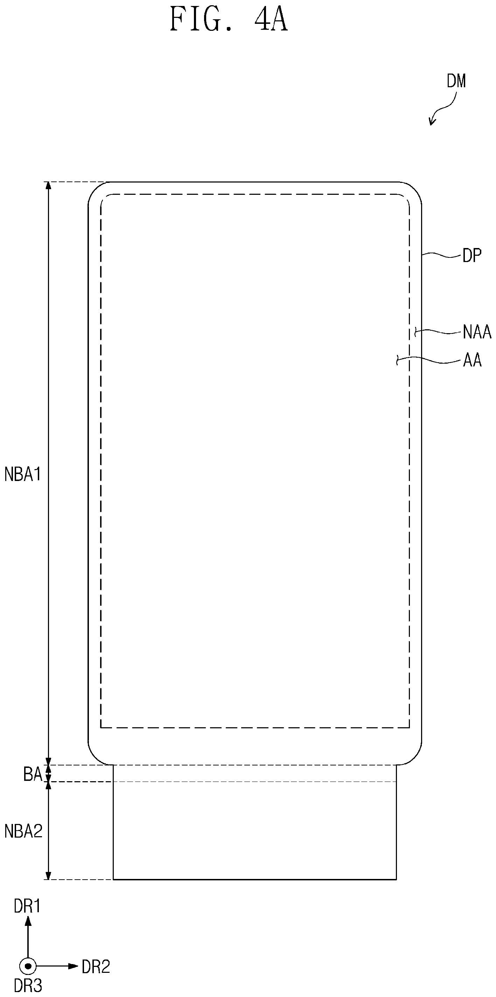

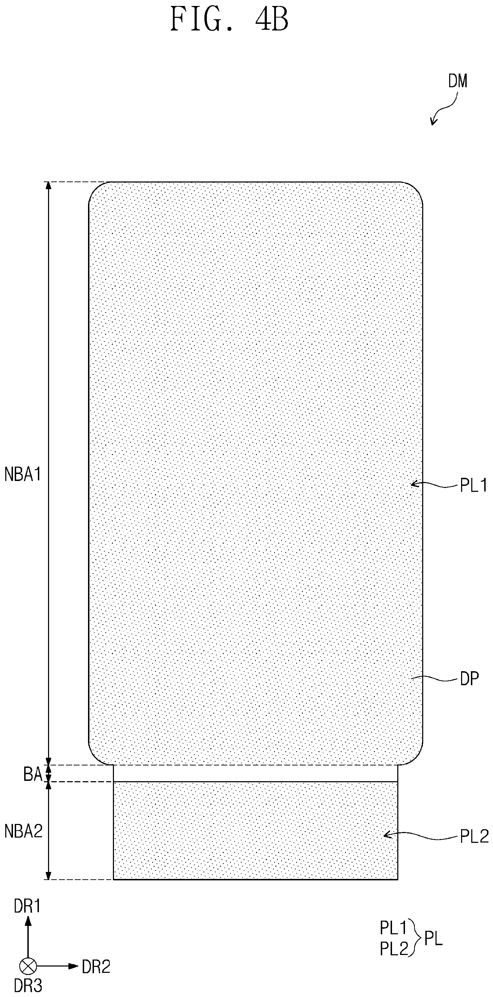

FIG. 4A is a plan view of a display module according to an embodiment of the present inventive concept. FIG. 4B is a rear view of a display module according to an embodiment of the present inventive concept.

Referring to FIGS. 4A and 4B, a display module DM may include a display panel DP and a protective layer PL disposed under the display panel DP (e.g., in a direction opposite to the third direction DR3). The display module DM may be composed of the display panel DP and the protective layer PL.

The protective layer PL may be disposed directly under the display panel DP (e.g., in a direction opposite to the third direction DR3). In an embodiment, the protective layer PL may include a first protective layer PL1 overlapping a first non-bending region NBA1, and a second protective layer PL2 overlapping a second non-bending region NBA2. In an embodiment, the first protective layer PL1 and the second protective layer PL2 may be members which are composed of the substantially same material as each other, except that the overlapping region of the first protective layer PL1 is different from that of the second protective layer PL2. For example, in an embodiment the first protective layer PL1 and the second protective layer PL2 may be simultaneously formed of the same material through the same process as each other. The first protective layer PL1 and the second protective layer PL2 may have the substantially same thickness as each other. In this specification, the wording "substantially same" may include not only a case in which the thicknesses, etc. of components are physically and completely identical, but also a case in which there is a difference as much as a tolerance range that occurs during the process, despite the same design.

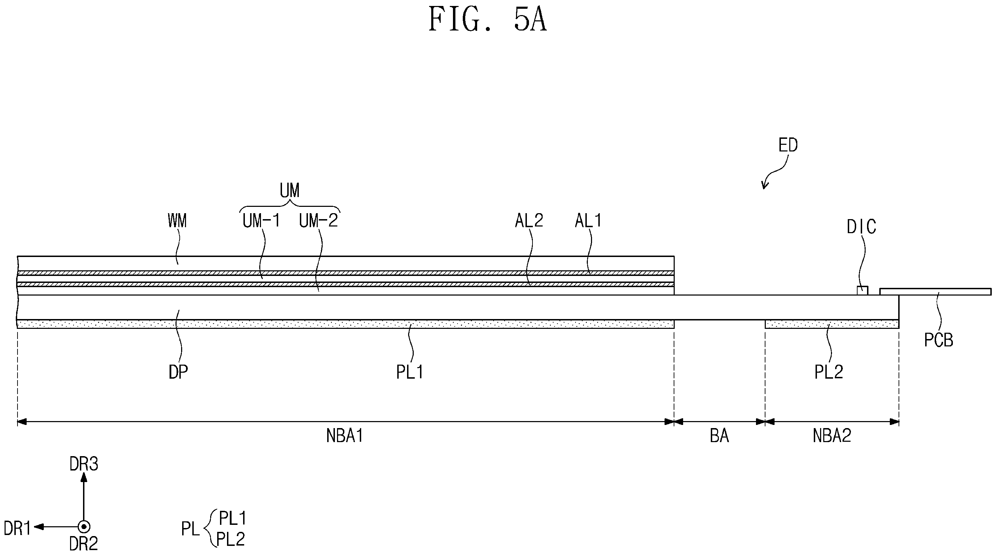

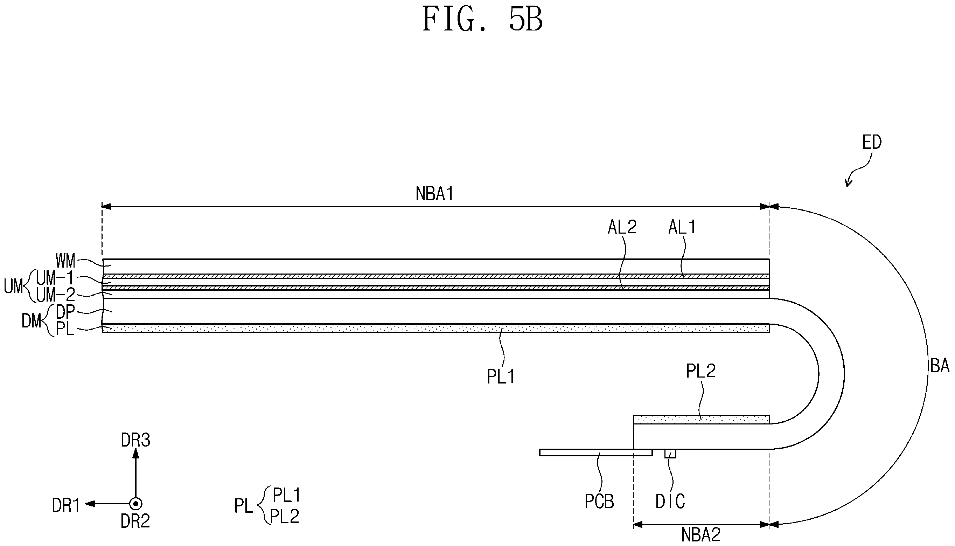

FIGS. 5A and 5B are cross-sectional views illustrating a partial configuration of an electronic apparatus according to an embodiment of the present inventive concept. FIG. 5A illustrates a state in which a display panel DP is not bent in an electronic apparatus ED according to an embodiment of the present inventive concept. FIG. 5B illustrates a state in which a bending region BA of a display panel DP is bent in an electronic apparatus ED according to an embodiment of the present inventive concept. Hereinafter, components same as/similar to the components illustrated in FIGS. 1 to 4B will be denoted as same/similar reference numerals or symbols, and a duplicated explanation may be omitted for economy of explanation.

Referring to FIGS. 5A and 5B, an electronic apparatus ED according to an embodiment of the present inventive concept may include a window WM, an upper member UM, and a display module DM. The electronic apparatus ED may include a front surface and a rear surface (e.g., opposite to each other in the third direction DR3). The front surface of the electronic apparatus ED may be defined by the window WM, and the rear surface of the electronic apparatus ED may be defined by a protective layer PL.

The window WM may cover a front surface of a display panel DP. In an embodiment, the window WM may include a base substrate and a bezel pattern. In an embodiment, the base substrate may include a transparent base layer such as a glass substrate or a transparent film. The bezel pattern may have a multi-layered structure. The multi-layered structure may include a colored color-layer and a light shielding layer of black color.

In an embodiment, the upper member UM may include an anti-reflection layer UM-1 and an input sensor UM-2. In an embodiment, the window WM and the anti-reflection layer UM-1 may be coupled to each other through a first adhesive layer AL1, and the anti-reflection layer UM-1 and the input sensor UM-2 may be coupled to each other through a second adhesive layer AL2. However, embodiments of the present inventive concept are not necessarily limited thereto and at least one of the first adhesive layer AL1 or the second adhesive layer AL2 may be omitted. For example, in an embodiment the second adhesive layer AL2 may be omitted, and the anti-reflection layer UM-1 may be disposed directly on the input sensor UM-2.

The anti-reflection layer UM-1 may reduce external light reflectance. The anti-reflection layer UM-1 may include a phase retarder and/or a polarizer. The anti-reflection layer UM-1 may include a polarizing film or color filters. The color filters may have a predetermined arrangement. The arrangement of the color filters may be determined in consideration of colors of light emitted from pixels included in the display panel DP. The anti-reflection layer UM-1 may further include a division layer adjacent to the color filters.

In an embodiment, the input sensor UM-2 may include a plurality of sensing electrodes for sensing an external input, trace lines connected to the plurality of sensing electrodes, and an inorganic layer and/or an organic layer for insulating/protecting the plurality of sensing electrodes or the trace lines. In an embodiment, the input sensor UM-2 may be a capacitive sensor. However, embodiments of the present inventive concept are not necessarily limited thereto.

In an embodiment, when the display panel DP is manufactured, the input sensor UM-2 may be formed directly on a thin-film encapsulation layer (e.g., in the third direction DR3) through a continuous process. However, embodiments of the present inventive concept are not necessarily limited thereto, and the input sensor UM-2 may be prepared as a separate panel from the display panel DP and attached to the display panel DP by an adhesive layer in some embodiments.

The display module DM may include the display panel DP and the protective layer PL disposed under the display panel DP. The protective layer PL may be disposed directly under the display panel DP (e.g., in a direction opposite to the third direction DR3). In an embodiment, the protective layer PL may be in direct contact with a lower surface of the display panel DP. An additional adhesive member may not be disposed between the protective layer PL and the display panel DP (e.g., in the third direction DR3). In an embodiment, the protective layer PL may have a thickness in a range of about 50 µm to about 300 µm. For example, the protective layer PL may have a thickness in a range of about 100 µm to about 200 µm.

In the display module DM according to an embodiment, the protective layer PL may be provided in a single-layer form directly on the lower surface of the display panel DP. In an embodiment, the protective layer PL may be a member which supports the display panel DP, absorbs impacts applied to the display panel DP, and performs a heat-dissipating function for dissipating heat generated from components, for example, an electronic module, which are disposed under the display panel DP. Since the protective layer PL, in the single-layer form, simultaneously performs a shock-absorbing function, a heat-dissipating function, and the like, a thickness of the electronic apparatus ED may be reduced and components thereof may be simplified, thereby increasing process efficiency in manufacture of the electronic apparatus ED according to an embodiment. However, embodiments of the present inventive concept are not necessarily limited thereto, and in some embodiments the electronic apparatus ED may further include at least one of a shock-absorbing layer, a heat-dissipating layer, a shielding layer, or a supporting layer which is disposed under the protective layer PL.

The protective layer PL may include a base resin. The protective layer PL may include a base resin having a curing property. For example, the protective layer PL may include a thermosetting resin or a photocurable resin. In an embodiment, the protective layer PL may include at least one of an acrylate-based resin, a urethane-based resin, a fluorine-based resin, an epoxy-based resin, a polyester-based resin, a polyamide-based resin, or a silicone-based resin, which has a curing property. The protective layer PL may include a plurality of fillers dispersed in the base resin. The plurality of fillers may each perform a shielding function, a heat-dissipating function, or a shock-absorbing function.

In an embodiment, the protective layer PL may include a first protective layer PL1 overlapping a first non-bending region NBA1, and a second protective layer PL2 overlapping a second non-bending region NBA2. On a plane defined by a first direction DR1 and a second direction DR2, the first protective layer PL1 and the second protective layer PL2 may not overlap each other and may be spaced apart from each other by a bending region BA disposed therebetween (e.g., in a first direction DR1). Since the protective layer PL is not disposed in the bending region BA, stress occurring in the circuit layer DP-CL (see FIG. 3) during bending of the display panel DP may be reduced.

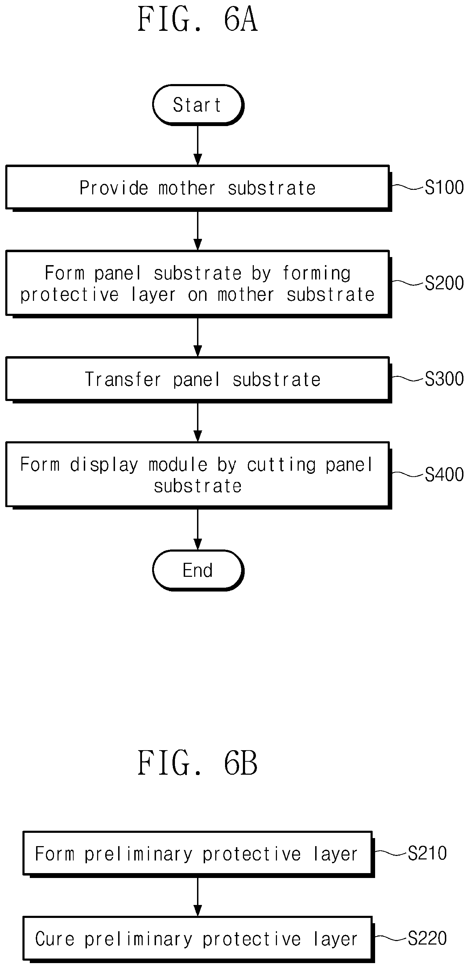

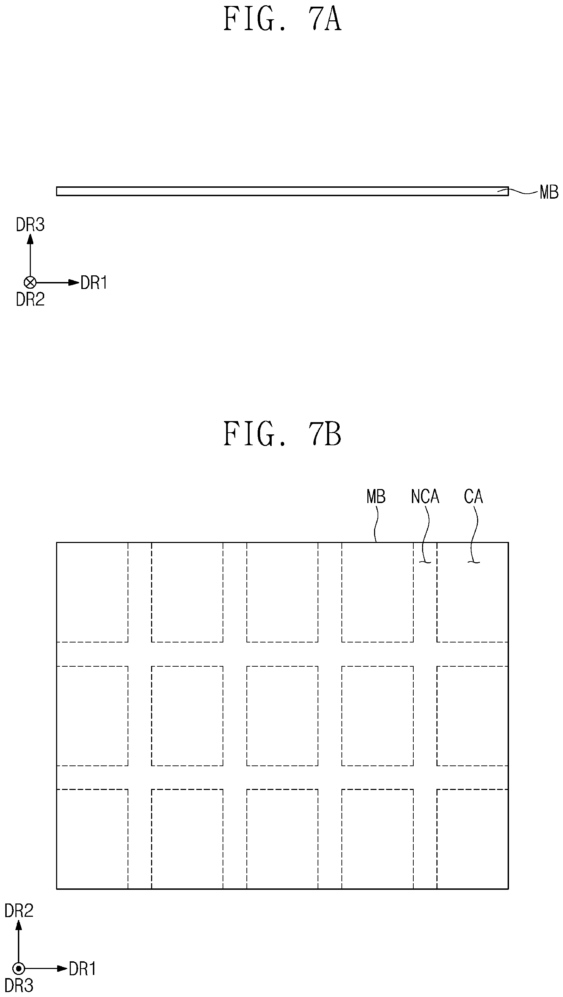

FIG. 6A is a flowchart illustrating a method of manufacturing a display module according to an embodiment of the present inventive concept. FIG. 6B is a flowchart illustrating some steps of a method of manufacturing a display module according to an embodiment of the present inventive concept. FIGS. 7A to 10B illustrate some steps of a method of manufacturing a display module according to embodiments of the present inventive concept. A method of manufacturing a display module according to an embodiment of the present inventive concept may illustrate a method of manufacturing the display module DM which has been described with reference to FIGS. 1 to 5B. Hereinafter, in the description of a method of manufacturing a display module DM according to embodiments of the present inventive concept with reference to FIGS. 6A to 10B, components which are the same as the aforementioned components will be given the same reference numerals or symbols and detailed descriptions thereof may be omitted for economy of explanation.

Referring to FIG. 6A, a method of manufacturing a display module according to an embodiment of the present inventive concept may include a step of providing a mother substrate in block S100, a step of forming a panel substrate by forming a protective layer on the mother substrate in block S200, a step of transferring the panel substrate in block S300, and a step of forming a display module by cutting the panel substrate in block S400. Referring to FIG. 6B, in the method of manufacturing the display module DM according to an embodiment of the present inventive concept, the step of forming the panel substrate by forming the protective layer on the mother substrate in block S200 may include a step of forming a preliminary protective layer in block S210 and a step of curing the preliminary protective layer in block S220.

Referring to FIG. 6A, and FIGS. 7A and 7B, the step of providing a mother substrate MB in block S100 may be performed. In an embodiment, the mother substrate MB may include a plurality of cell regions CA and a peripheral region NCA surrounding each of the plurality of cell regions CA (e.g., in a plan view). In an embodiment, the plurality of cell regions CA may be disposed spaced apart from each other in a first direction DR1 and a second direction DR2. For example, cell regions CA, which are adjacent to each other, among the plurality of cell regions CA may be spaced apart from each other by the same distance in the first direction DR1 and the second direction DR2. The space between the plurality of cell regions CA, which are spaced apart from each other, may be defined as the peripheral region NCA. In an embodiment, the plurality of cell regions CA may each have a quadrangular shape. In an embodiment, the plurality of cell regions CA may have the same size and shape as each other. However, embodiments of the present inventive concept are not necessarily limited thereto, and the plurality of cell regions CA may have sizes and shapes different from each other.

In an embodiment, the mother substrate MB may include a preliminary base layer, a preliminary circuit layer disposed on the preliminary base layer, and a preliminary light-emitting element layer disposed on the preliminary circuit layer. A configuration of the preliminary base layer, the preliminary circuit layer, and the preliminary light-emitting element layer may be similar/identical to the configuration of the base layer BL, the circuit layer DP-CL, and the light-emitting element layer DP-ED, illustrated in FIG. 3. For example, the mother substrate MB may be a member used in an intermediate stage of manufacturing a display panel DP, and may thus be referred to as a preliminary display panel. The mother substrate MB may then be cut corresponding to the plurality of cell regions CA. The mother substrate MB that is cut corresponding to one cell region CA may be one component of the display module DM illustrated in FIG. 1.

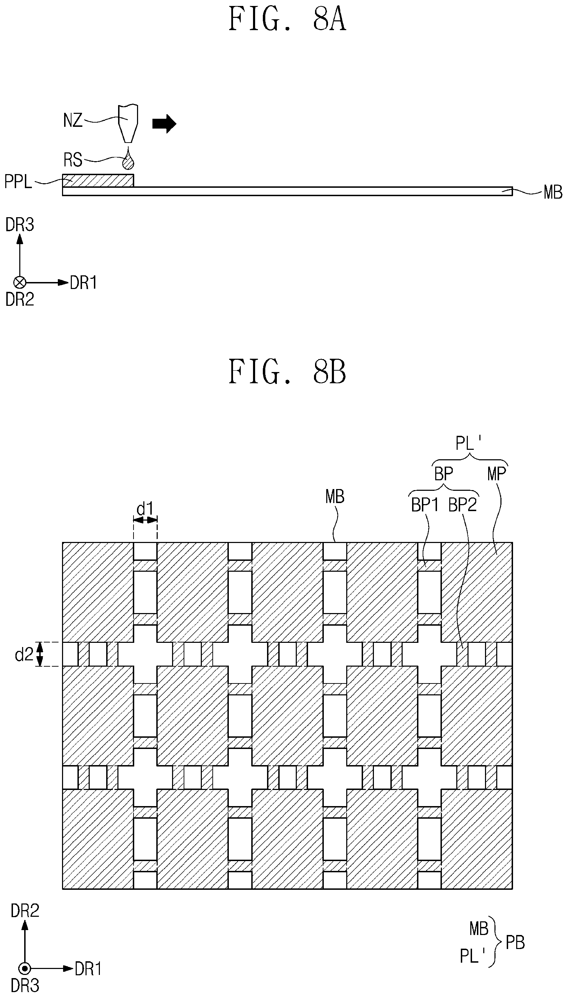

Referring to FIG. 6A, and FIGS. 8A and 8B, the step of forming a panel substrate PB by forming a protective layer PL' on the mother substrate MB in block S200 may be performed. The panel substrate PB may include the mother substrate MB and the protective layer PL' formed on the mother substrate MB. The protective layer PL' may correspond to the protective layer PL illustrated in FIG. 2. However, embodiments of the present inventive concept are not necessarily limited thereto, and the protective layer PL' may be one component of an upper member UM disposed on the display module DM.

Referring to FIG. 8A, in an embodiment a resin composition RS may be applied onto (e.g., applied directly thereon in the third direction DR3) the mother substrate MB using a nozzle NZ. For example, the resin composition RS may be applied onto a top surface of the mother substrate MB. The nozzle NZ may move in a first direction DR1 above the mother substrate MB, and apply the resin composition RS onto the mother substrate MB. In an embodiment, the resin composition RS may include a curable resin. For example, the resin composition RS may include at least one of an acrylate-based resin, a urethane-based resin, a fluorine-based resin, an epoxy-based resin, a polyester-based resin, a polyamide-based resin, or a silicone-based resin, which has a curing property. The curable resin included in the resin composition RS may be in a liquid form before being cured.

According to an embodiment of the present inventive concept, the resin composition RS may be applied onto the mother substrate MB through at least any one of a spin coating method, a slit coating method, a jet printing method, a metal mask printing method, or a screen printing method. For example, the resin composition RS may be applied through a screen printing process, or a slit coating process.

The resin composition RS may be applied directly onto the mother substrate MB (e.g., in the third direction DR3). Accordingly, an additional adhesive layer between the display panel DP and the protective layer PL that is formed thereafter (e.g., in the third direction DR3), illustrated in FIG. 2, may be unnecessary, and thus the reliability of an electronic apparatus ED having the display panel DP and the protective layer PL may be increased.

Referring to FIG. 6B, and FIGS. 8A and 8B, the step of forming the protective layer PL' may include the step of forming a preliminary protective layer PPL in block S210 and the step of curing the preliminary protective layer PPL in block S220. The preliminary protective layer PPL may be the resin composition RS which is in a liquid form before being cured. For example, the resin composition RS in the liquid form before being cured may be applied onto the mother substrate MB, and thus the preliminary protective layer PPL may be formed. In an embodiment, the protective layer PL' may then be formed by providing light to the preliminary protective layer PPL. For example, the light may be ultraviolet light having a central wavelength in a wavelength range of about 100 nm to about 400 nm. The preliminary protective layer PPL may include a curable resin, and may be photocured by receiving light. However, embodiments of the present inventive concept are not necessarily limited thereto. For example, in an embodiment the step of curing the preliminary protective layer PPL in block S220 may be a step of forming the protective layer PL' by providing heat to the preliminary protective layer PPL. For example, the preliminary protective layer PPL may be thermally cured by receiving heat.

The resin composition RS may be applied uniformly onto the mother substrate MB. However, the resin composition RS may not be applied onto some regions of the mother substrate MB. For example, as illustrated in FIG. 8B, the protective layer PL' formed on the mother substrate MB may be applied to the cell regions CA (see FIG. 7B) and a portion of the peripheral region NCA (see FIG. 7B), in the mother substrate MB. According to an embodiment of the present inventive concept, the protective layer PL' may include a plurality of main parts MP and a plurality of bridge patterns BP connecting the plurality of main parts MP to each other.

The plurality of main parts MP may be disposed corresponding to the plurality of cell regions CA of the mother substrate MB illustrated in FIG. 7B. For example, each of the plurality of main parts MP may overlap a cell region of the plurality of cell regions CA. Accordingly, in an embodiment the plurality of main parts MP may each have a quadrangular shape. In an embodiment, the plurality of main parts MP may have the same size and shape as each other. However, embodiments of the present inventive concept are not necessarily limited thereto, and the plurality of main parts MP may be different from each other in size and/or shape in some embodiments. The plurality of main parts MP may be disposed to be spaced apart from each other in a first direction DR1 and a second direction DR2. The plurality of main parts MP may be disposed to be spaced apart from each other in the first direction DR1 by a first distance d1, and in the second direction DR2 by a second distance d2. In an embodiment, the first distance d1 and the second distance d2 may be the same as each other.

The plurality of bridge patterns BP may be disposed in the peripheral region NCA surrounding each of the plurality of cell regions CA of the mother substrate MB illustrated in FIG. 7B. For example, each of the plurality of bridge patterns BP may overlap the peripheral region NCA. The bridge patterns BP may each connect one surface of one main part MP among the main parts MP to one surface of a main part MP adjacent to the one main part MP. According to an embodiment of the present inventive concept, the bridge patterns BP may respectively extend from the main parts MP. For example, in an embodiment the bridge patterns BP and the main parts MP may be formed integrally since the bridge patterns BP and the main parts MP are formed through the same process.

In an embodiment, the bridge patterns BP may include a first bridge pattern BP1 and a second bridge pattern BP2. The first bridge pattern BP1 may be disposed between the main parts MP spaced apart from each other in the first direction DR1, and the second bridge pattern BP2 may be disposed between the main parts MP spaced apart from each other in the second direction DR2. In an embodiment, the first bridge pattern BP1 and the second bridge pattern BP2 may each be provided in plurality. For example, in FIG. 8B, it is illustrated that the number of the first bridge patterns BP1 and the number of the second bridge patterns BP2, which connect one surface of one main part MP to one surface of a main part MP adjacent to the one main part MP, are each two. However, embodiments of the present inventive concept are not necessarily limited thereto. For example, in an embodiment the number of the first bridge patterns BP1 and the number of the second bridge patterns BP2, which connect one surface of one main part MP to one surface of a main part MP adjacent to the one main part MP, may each be three or more.

The first bridge patterns BP1 may extend in the first direction DR1, and may be arranged in the second direction DR2. The second bridge patterns BP2 may extend in the second direction DR2, and may be arranged in the first direction DR1. In an embodiment as shown in FIG. 8B, the first bridge patterns BP1 and the second bridge patterns BP2 may have a line shape extending in the first direction DR1 and second direction DR2, respectively, in a plan view. However, embodiments of the present inventive concept are not necessarily limited thereto. As illustrated in FIG. 8B, a plurality of openings may be defined in the protective layer PL' by the main parts MP, the first bridge patterns BP1, and the second bridge patterns BP2. In an embodiment, a thickness of the main parts MP in the third direction DR3 (e.g., a vertical direction) may be different from a thickness of the bridge patterns BP in the third direction DR3 (e.g., the vertical direction). For example, in an embodiment, the bridge patterns BP may have a smaller thickness than the main parts MP. When the resin composition RS is applied onto the mother substrate MB in FIG. 8A, the thickness of the main parts MP and the thickness of the bridge patterns BP may be formed to be different from each other by controlling the amount of the resin composition RS applied.

In a method of manufacturing the display module DM (see FIG. 2) according to an embodiment of the present inventive concept, the protective layer PL' may be formed through a large-area coating method such as slit coating or screen printing. Thus, a separate adhesive may not be used, and therefore the manufacturing efficiency of the display module DM may be increased.

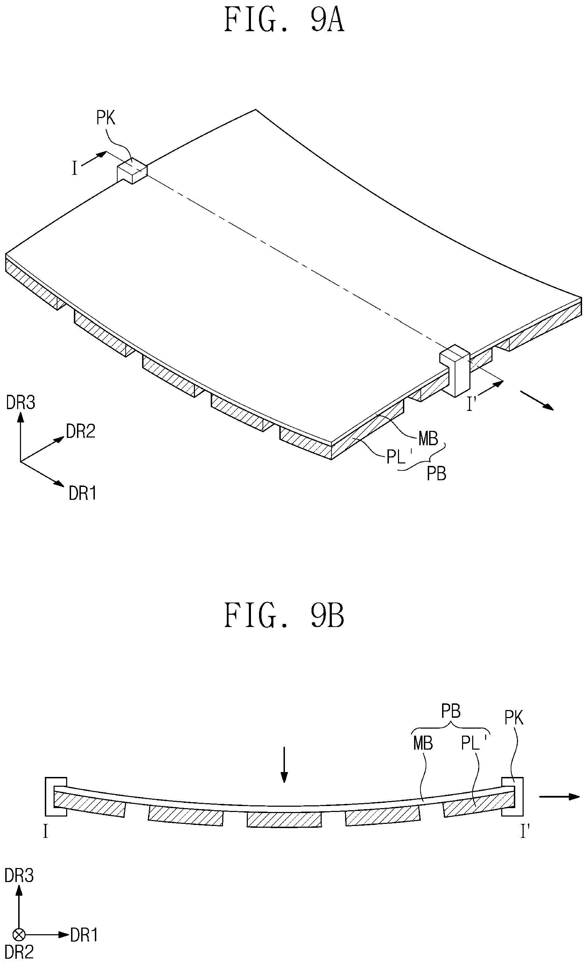

Referring to FIG. 6A, and FIGS. 9A and 9B, the step of transferring a panel substrate PB in block S300 may be performed. FIG. 9B is a cross-sectional view of the panel substrate PB taken along line I-I' in FIG. 9A. In an embodiment, the panel substrate PB may be transferred in a first direction DR1 by a picking device PK. In an embodiment, the panel substrate PB illustrated in FIGS. 9A and 9B may have an inverted phase of that of the panel substrate PB illustrated in FIGS. 8A and 8B. For example, the step of transferring the panel substrate PB in block S300 may be performed after the panel substrate PB illustrated in FIGS. 8A and 8B is inverted.

In an embodiment, the picking device PK may transfer the panel substrate PB while being fixed to both side surfaces, which are spaced apart from each other in a first direction DR1, of the panel substrate PB. However, embodiments of the present inventive concept are not necessarily limited thereto. For example, in an embodiment four picking devices PK may be provided to be disposed at respective corners of the panel substrate PB, and may transfer the panel substrate PB.

Since the picking device PK transfers the panel substrate PB in the first direction DR1 while being fixed to both side surfaces of the panel substrate PB, the panel substrate PB may be transferred while sagging (for example, in a direction opposite to a third direction DR3) due to gravity. The mother substrate MB may be likely to be damaged by receiving tensile force in the first direction DR1 and the opposite direction of the first direction DR1 during the transfer of the panel substrate PB. However, when the panel substrate PB according to an embodiment of the present inventive concept is compared with a panel substrate according to Comparative Examples in which a plurality of bridge patterns BP are not disposed under the mother substrate MB, a degree of sagging of the panel substrate PB in the direction opposite to the third direction DR3 during the transfer of the panel substrate PB may be reduced by about three to four times as compared to the degree of sagging of the panel substrate according to Comparative Examples. For example, the tensile force may be dispersed by the plurality of bridge patterns BP disposed under the mother substrate MB during the transfer of the panel substrate PB, thereby reducing a possibility of damage to the mother substrate MB. Therefore, the display module DM (see FIG. 2) with increased reliability may be provided.

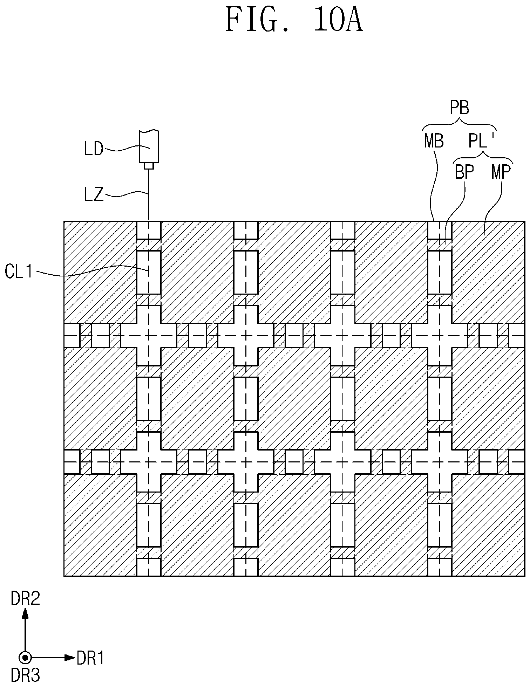

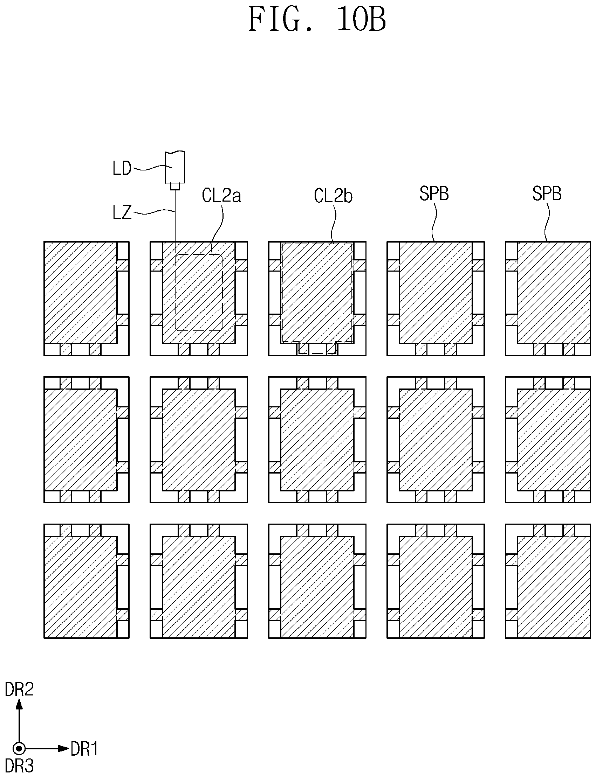

Referring to FIG. 6A, and FIGS. 10A and 10B, the step of forming the display module DM (see FIG. 2) by cutting the panel substrate PB in block S400 may be performed. FIG. 10A illustrates a first cutting step of cutting the panel substrate PB along a first cutting line CL1, and FIG. 10B illustrates a second cutting step of cutting a plurality of divided sub-panel substrates SPB along second cutting lines CL2a and CL2b.

Referring to FIG. 10A, the first cutting line CL1 may be formed in the peripheral region NCA (see FIG. 7B). A laser irradiation device LD according to an embodiment of the present inventive concept may cut the panel substrate PB by irradiating the first cutting line CL1 of the panel substrate PB with the laser LZ. The laser irradiation device LD may cut the panel substrate PB while moving along the first cutting line CL1. The first cutting line CL1 may overlap the plurality of bridge patterns BP. For example, the first cutting step may be a step of simultaneously cutting the mother substrate MB and the plurality of bridge patterns BP along the first cutting line CL1.

In an embodiment, a thickness of the panel substrate PB in which the plurality of bridge patterns BP are not disposed may be less than a thickness of the panel substrate PB in which the plurality of bridge patterns BP are disposed. Accordingly, in the first cutting step of cutting the panel substrate PB according to an embodiment of the present inventive concept, a cutting load may be reduced compared to the case of performing a step of cutting the panel substrate PB in which the protective layer PL' is formed on an entirety of the lower surface of the mother substrate MB. Thus, a manufacturing process of the display module DM (see FIG. 2) may be simplified.

Referring to FIGS. 10A and 10B, the panel substrate PB may be divided into the plurality of sub-panel substrates SPB after the first cutting step. The plurality of sub-panel substrates SPB may each correspond to the display module DM (see FIG. 2) illustrated in FIG. 2.

Referring to FIG. 10B, the second cutting lines CL2a and CL2b may be formed in the cell region CA (see FIG. 7B). The laser irradiation device LD may cut the sub-panel substrates by irradiating the second cutting lines CL2a and CL2b of the plurality of sub-panel substrates SPB with the laser LZ. In an embodiment, the laser irradiation device LD may cut the plurality of sub-panel substrates SPB while moving along the second cutting lines CL2a and CL2b. In an embodiment, the second cutting lines CL2a and CL2b may be formed in each of the plurality of sub-panel substrates SPB, and the plurality of sub-panel substrates SPB may each be cut by the laser irradiation device LD.

The second cutting lines CL2a and CL2b may overlap the plurality of main parts MP. For example, in an embodiment the second cutting step may be a step of simultaneously cutting the mother substrate MB and the plurality of main parts MP along the second cutting line CL2a, or a step of simultaneously cutting the mother substrate MB, the plurality of main parts MP, and the plurality of bridge patterns BP along the second cutting line CL2b. The display module DM (see FIG. 2) may be formed after the second cutting step. Like the display module DM illustrated in FIG. 2, a bending region BA and a second non-bending region NBA2 may be defined in the display module DM which is formed along the second cutting line CL2b. However, unlike the display module DM illustrated in FIG. 2, the bending region BA and the second non-bending region NBA2 may not be defined in the display module DM which is formed along the second cutting line CL2a. For example, the shape of the display module DM may vary depending on the second cutting lines CL2a and CL2b. After the second cutting step, the plurality of sub-panel substrates SPB may each be manufactured as one display module DM.

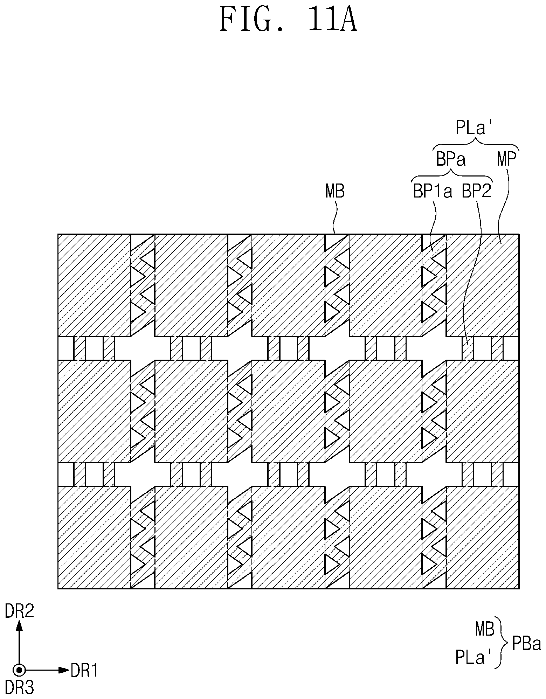

FIGS. 11A to 11D are plan views illustrating a panel substrate according to embodiments of the present inventive concept. Hereinafter, description duplicated with that previously described may be omitted for economy of explanation.

Referring to FIG. 11A, a panel substrate PBa may include a mother substrate MB and a protective layer PLa' disposed on (e.g., disposed directly thereon) the mother substrate MB. The protective layer PLa' may include a plurality of main parts MP and a plurality of bridge patterns BPa connecting the plurality of main parts MP to each other. In an embodiment, the plurality of bridge patterns BPa may include a first bridge pattern BP1a and a second bridge pattern BP2.

According to an embodiment of the present inventive concept, a shape of the first bridge pattern BP1a and a shape of the second bridge pattern BP2 may be different from each other. For example, in an embodiment the first bridge pattern BP1a may extend in a second direction DR2, and have a zigzag shape in a plan view. In an embodiment, the shape of the second bridge pattern BP2 may be the same as the shape of the second bridge pattern BP2 illustrated in FIG. 8B, such as a line shape extending in the second direction DR2 in a plan view. In an embodiment, the first bridge patterns BP1a may be disposed in all regions between one surface of one main part MP and one surface of a main part MP adjacent to the one main part MP in the first direction DR1 and the second bridge patterns BP2 may be disposed between one surface of one main part MP and one surface of a main part MP adjacent to the one main part MP in the second direction DR2. However, embodiments of the present inventive concept are not necessarily limited thereto, and the first bridge pattern BP1a may not be disposed in an outer region of the mother substrate MB in some embodiments.

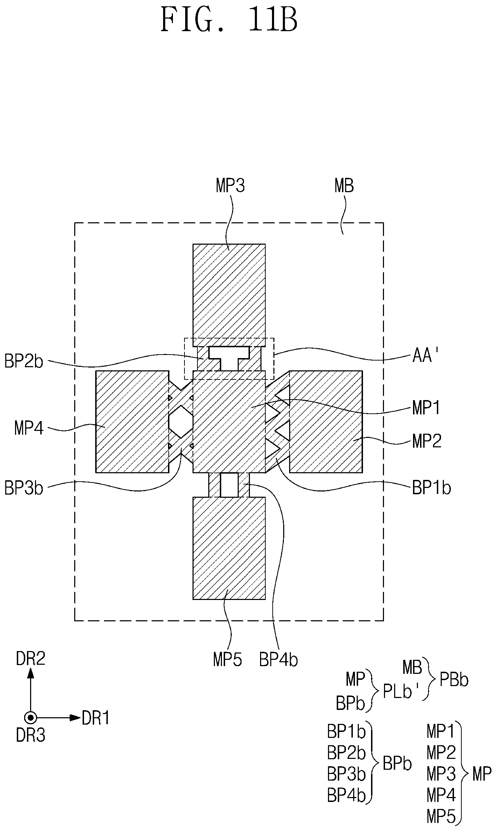

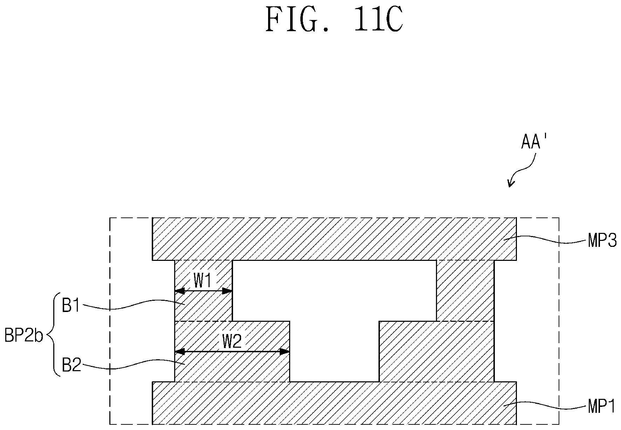

FIG. 11B illustrates a portion of a panel substrate PBb. FIG. 11C is an enlarged view of the AA' region illustrated in FIG. 11B. A protective layer PLb' of the panel substrate PBb may include a plurality of main parts MP and a plurality of bridge patterns BPb connecting the plurality of main parts MP to each other. The plurality of main parts MP may include first to fifth main parts MP1, MP2, MP3, MP4, and MP5. When centered around the first main part MP1, the second main part MP2 may be disposed spaced apart from the first main part MP1 in a first direction DR1, the third main part MP3 may be disposed spaced apart from the first main part MP1 in a second direction DR2, the fourth main part MP4 may be disposed spaced apart from the first main part MP1 in a direction opposite to the first direction DR1, and the fifth main part MP5 may be disposed spaced apart from the first main part MP1 in a direction opposite to the second direction DR2. For example, the second to fifth main parts MP2, MP3, MP4, and MP5 may be disposed to be facing respective sides of the first main part MP1.

In an embodiment, the plurality of bridge patterns BPb may include first to fourth bridge patterns BP1b, BP2b, BP3b, and BP4b. The first bridge pattern BP1b may connect the first main part MP1 and the second main part MP2 to each other, the second bridge pattern BP2b may connect the first main part MP1 and the third main part MP3 to each other, the third bridge pattern BP3b may connect the first main part MP1 and the fourth main part MP4 to each other, and the fourth bridge pattern BP4b may connect the first main part MP1 and the fifth main part MP5 to each other. The first to fourth bridge patterns BP1b, BP2b, BP3b, and BP4b may each extend from (e.g., extend directly therefrom) the first main part MP1. In an embodiment, the first to fourth bridge patterns BP1b, BP2b, BP3b, and BP4b and the first to fifth main parts MP1, MP2, MP3, MP4, and MP5 may be formed through the same process, and thus be formed integrally.

According to an embodiment of the present inventive concept, the first to fourth bridge patterns BP1b, BP2b, BP3b, and BP4b may respectively have different shapes from each other. For example, a shape of the first bridge pattern BP1b in a plan view may be same as the shape of the first bridge pattern BP1a illustrated in FIG. 11A, such as a zigzag shape extending in the second direction DR2, and a shape of the fourth bridge pattern BP4b in a plan view may be the same as the shape of the second bridge pattern BP2 illustrated in FIG. 8B, such as a line shape extending in the second direction DR2. Accordingly, a repeated description thereof may be omitted for economy of explanation. In an embodiment, the shapes of the plurality of bridge patterns BPb may include at least two of a line shape, an X-shape, a zigzag shape and an L-shape in the plan view.

Referring to FIGS. 11B and 11C together, the second bridge pattern BP2b may include a first portion B1 extending directly from the third main part MP3, and a second portion B2 extending directly from the first portion B1 and from the first main part MP1. According to an embodiment of the present inventive concept, a first width W1 of the first portion B1 in the first direction DR1 may be different from a second width W2 of the second portion B2 in the first direction DR1. For example, the second width W2 may be greater than the first width W1. In an embodiment, the second bridge pattern BP2b may be provided in plurality. For example, the number of the second bridge patterns BP2b illustrated in FIG. 11B is two. However, embodiments of the present inventive concept are not necessarily limited thereto. A shape of the display module DM (see FIG. 2) which is formed from the third main part MP3 may correspond to the shape of the display module DM illustrated in FIG. 2. For example, like the display module DM illustrated in FIG. 2, a bending region BA and a second non-bending region NBA2 may be defined in the display module DM which is formed from the third main part MP3.

Referring to FIG. 11B again, the third bridge pattern BP3b may have a shape of an 'X' in a plan view. In an embodiment, the third bridge pattern BP3b may be provided in plurality. For example, the number of the third bridge patterns BP3b illustrated in FIG. 11B is two. However, embodiments of the present inventive concept are not necessarily limited thereto. For example, the number of the third bridge patterns BP3b may be three or more in some embodiments.

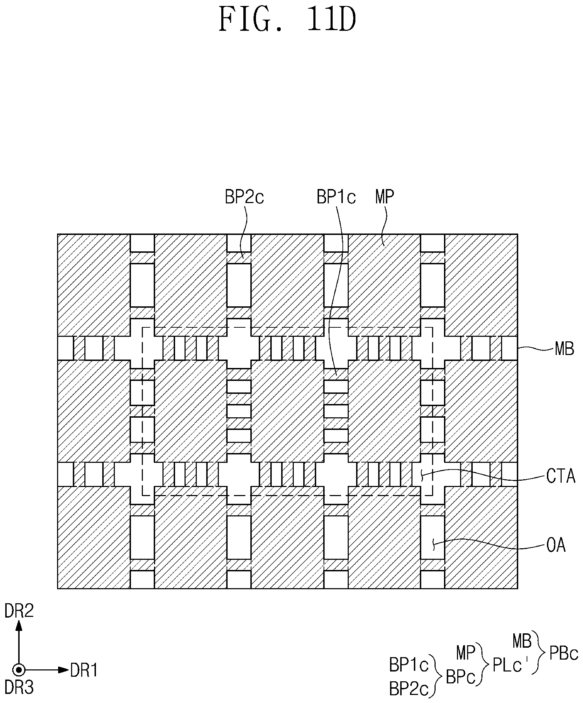

Referring to FIG. 11D, a central region CTA and an outer region OA surrounding the central region CTA (e.g., in a plan view) may be defined in a protective layer PLc'. A plurality of bridge patterns BPc may include a plurality of first bridge patterns BP1c disposed in the central region CTA and a plurality of second bridge patterns BP2c disposed in the outer region OA. The first bridge patterns BP1c and the second bridge patterns BP2c may be defined as patterns formed between one surface of one main part MP and one surface of a main part MP adjacent to the one main part MP (e.g., in the first direction DR1). According to an embodiment of the present inventive concept, the number of the first bridge patterns BP1c may be greater than the number of the second bridge patterns BP2c. However, embodiments of the present inventive concept are not necessarily limited thereto.

When a panel substrate PBc according to an embodiment of the present inventive concept is transferred in a first direction DR1 as illustrated in FIGS. 9A and 9B, the panel substrate PBc may be transferred while sagging in the direction opposite to the third direction DR3. Tensile force may be concentrated on the central region CTA of the mother substrate MB during the transfer of the panel substrate PBc. For this reason, arrangement of the first bridge patterns BP1c may cause the tensile force to be dispersed in the central region CTA of the mother substrate MB to reduce sagging of the mother substrate MB, thereby reducing a possibility of damage to the mother substrate MB.

Since a plurality of bridge patterns are disposed under a mother substrate (e.g., directly thereunder), tensile force applied to the mother substrate during transfer of a panel substrate may be dispersed, thereby reducing a possibility of damage to the mother substrate. Therefore, the reliability of a display module which is formed using the panel substrate may be increased.

In the above, description has been made with reference to non-limiting embodiments, but those skilled in the art or those of ordinary skill in the relevant technical field may understand that various modifications and changes may be made to embodiments of the present inventive concept without departing from the technology scope of the present inventive concept.

Therefore, the technical scope of embodiments of the present inventive concept is not limited to the contents described in the detailed description of the specification.

Embodiments are set out in the following clauses:
Clause 1. A panel substrate comprising:
   a mother substrate including a plurality of cell regions and a peripheral region surrounding the plurality of cell regions; and
   a protective layer disposed under the mother substrate,
   wherein the protective layer includes:
      a plurality of main parts overlapping the plurality of cell regions, and
      a plurality of bridge patterns overlapping the peripheral region, the plurality of bridge patterns connecting main parts adjacent to each other among the plurality of main parts.
Clause 2. The panel substrate of clause 1, wherein the plurality of main parts comprise:
   a first main part;
   a second main part spaced apart from the first main part in a first direction; and
   a third main part spaced apart from the first main part in a second direction crossing the first direction.
Clause 3. The panel substrate of clause 2, wherein the plurality of bridge patterns comprise:
   a first bridge pattern connecting the first main part and the second main part to each other; and
   a second bridge pattern connecting the first main part and the third main part to each other.
Clause 4. The panel substrate of clause 3, wherein:
   the first bridge pattern includes a plurality of first bridge patterns; and
   the second bridge pattern includes a plurality of second bridge patterns.
Clause 5. The panel substrate of clause 4, wherein:
   the plurality of first bridge patterns extend in the first direction, and are arranged in the second direction; and
   the plurality of second bridge patterns extend in the second direction, and are arranged in the first direction.
Clause 6. The panel substrate of clause 3, wherein a shape of the first bridge pattern and a shape of the second bridge pattern are different from each other.
Clause 7. The panel substrate of clause 6, wherein the first bridge pattern has a zigzag shape extending in the second direction in a plan view.
Clause 8. The panel substrate of clause 6 or clause 7, wherein the second bridge pattern comprises:
   a first portion; and
   a second portion extending from the first portion,
   wherein a first width of the first portion in the first direction is different from a second width of the second portion in the first direction.
Clause 9. The panel substrate of any one of clauses 3 to 8, wherein the plurality of main parts further comprise:
   a fourth main part spaced apart from the first main part in a direction opposite to the first direction; and
   a fifth main part spaced apart from the first main part in a direction opposite to the second direction.
Clause 10. The panel substrate of clause 9, wherein the plurality of bridge patterns further comprise:
   a third bridge pattern connecting the first main part and the fourth main part to each other; and
   a fourth bridge pattern connecting the first main part and the fifth main part to each other.
Clause 11. The panel substrate of any one of clauses 2 to 10, wherein:
   the first main part and the second main part are spaced apart from each other by a first distance; and
   the first main part and the third main part are spaced apart from each other by a second distance,
   wherein the first distance and the second distance are equal to each other.
Clause 12. The panel substrate of any one of clauses 1 to 11, wherein:
   each of the plurality of main parts has a quadrangular shape in a plan view; and
   each of the plurality of bridge patterns connects one surface of one main part among the plurality of main parts to one surface of a main part of the plurality of main parts adjacent to the one main part.
Clause 13. The panel substrate of clause 12, wherein each of the plurality of main parts have a same shape and size as each other in the plan view.
Clause 14. The panel substrate of any one of clauses 1 to 13, wherein a number of the plurality of bridge patterns disposed in a central region of the protective layer is greater than a number of the plurality of bridge patterns disposed in an outer region of the protective layer that surrounds the central region.
Clause 15. The panel substrate of any one of clauses 1 to 14, wherein the plurality of main parts have a different thickness in a vertical direction than a thickness of the plurality of bridge patterns in the vertical direction.
Clause 16. The panel substrate of any one of clauses 1 to 15, wherein each bridge pattern of the plurality of bridge patterns extends from a respective main part of the plurality of main parts.
Clause 17. A method of manufacturing a display module, the method comprising:
   providing a mother substrate including a plurality of cell regions and a peripheral region surrounding the plurality of cell regions;
   forming a protective layer on the mother substrate to form a panel substrate; and
   cutting the panel substrate to form the display module,
   wherein the protective layer includes:
      a plurality of main parts overlapping the plurality of cell regions, and
      a plurality of bridge patterns overlapping the peripheral region, the plurality of bridge patterns connecting main parts adjacent to each other among the plurality of main parts.
Clause 18. The method of clause 17, wherein the forming of the protective layer comprises:
   applying a resin composition onto a top surface of the mother substrate to form a preliminary protective layer; and
   curing the preliminary protective layer.
Clause 19. The method of clause 18, wherein in the forming of the preliminary protective layer, the applying of the resin composition is performed through a screen printing process or a slit coating process.
Clause 20. The method of any one of clauses 17 to 19, wherein the cutting of the panel substrate comprises:
   performing a first cutting that cuts the panel substrate along a first cutting line overlapping the peripheral region to form a plurality of sub-panel substrates; and
   performing a second cutting that cuts the plurality of sub-panel substrates along a second cutting line corresponding to the plurality of cell regions.
Clause 21. The method of any one of clauses 17 to 20, further comprising transferring the panel substrate, after the forming of the panel substrate.
Clause 22. The method of any one of clauses 17 to 21, wherein the mother substrate comprises:
   a preliminary base layer;
   a preliminary circuit layer disposed on the preliminary base layer; and
   a preliminary light-emitting element layer disposed on the preliminary circuit layer.
Clause 23. A method of manufacturing a display module, the method comprising:
   providing a mother substrate;
   forming a protective layer directly on the mother substrate to form a panel substrate, the protective layer including a plurality of main parts, and a plurality of bridge patterns connecting main parts adjacent to each other among the plurality of main parts;
   transferring the panel substrate, wherein the plurality of bridge patterns increases a tensile force in a central region of the mother substrate during the transferring of the panel substrate to reduce sagging of the mother substrate; and
   cutting the panel substrate to form the display module after the transferring of the panel substrate.
Clause 24. The method of clause 23, wherein the protective layer is provided in a single-layer form and is composed of a cured resin composition.
Clause 25. The method of clause 23 or clause 24, wherein:
   at least some of the plurality of bridge patterns have shapes that are different from each other in a plan view,
   wherein the shapes of the plurality of bridge patterns include at least two of a line shape, an X-shape, a zigzag shape or an L-shape in the plan view.
Clause 26. The method of any one of clauses 23 to 25, wherein a number of the plurality of bridge patterns disposed in the central region of the protective layer is greater than a number of the plurality of bridge patterns disposed in an outer region of the protective layer that surrounds the central region.

## Claims

1. A panel substrate comprising:
a mother substrate including a plurality of cell regions and a peripheral region surrounding the plurality of cell regions; and
a protective layer disposed under the mother substrate,
wherein the protective layer includes:
a plurality of main parts overlapping the plurality of cell regions, and
a plurality of bridge patterns overlapping the peripheral region, the plurality of bridge patterns connecting main parts adjacent to each other among the plurality of main parts.

2. The panel substrate of claim 1, wherein the plurality of main parts comprise:
a first main part;
a second main part spaced apart from the first main part in a first direction; and
a third main part spaced apart from the first main part in a second direction crossing the first direction.

3. The panel substrate of claim 2, wherein the plurality of bridge patterns comprise:
a first bridge pattern connecting the first main part and the second main part to each other; and
a second bridge pattern connecting the first main part and the third main part to each other.

4. The panel substrate of claim 3, wherein:
the first bridge pattern includes a plurality of first bridge patterns; and
the second bridge pattern includes a plurality of second bridge patterns, optionally wherein:
the plurality of first bridge patterns extend in the first direction, and are arranged in the second direction; and
the plurality of second bridge patterns extend in the second direction, and are arranged in the first direction.

5. The panel substrate of claim 3, wherein a shape of the first bridge pattern and a shape of the second bridge pattern are different from each other.

6. The panel substrate of claim 5, wherein:
(i) the first bridge pattern has a zigzag shape extending in the second direction in a plan view; and/or
(ii) the second bridge pattern comprises:
a first portion; and
a second portion extending from the first portion,
wherein a first width of the first portion in the first direction is different from a second width of the second portion in the first direction.

7. The panel substrate of any one of claims 3 to 6, wherein the plurality of main parts further comprise:
a fourth main part spaced apart from the first main part in a direction opposite to the first direction; and
a fifth main part spaced apart from the first main part in a direction opposite to the second direction, optionally wherein the plurality of bridge patterns further comprise:
a third bridge pattern connecting the first main part and the fourth main part to each other; and
a fourth bridge pattern connecting the first main part and the fifth main part to each other.

8. The panel substrate of any one of claims 2 to 7, wherein:
the first main part and the second main part are spaced apart from each other by a first distance; and
the first main part and the third main part are spaced apart from each other by a second distance,
wherein the first distance and the second distance are equal to each other.

9. The panel substrate of any one of claims 1 to 8, wherein:
each of the plurality of main parts has a quadrangular shape in a plan view; and
each of the plurality of bridge patterns connects one surface of one main part among the plurality of main parts to one surface of a main part of the plurality of main parts adjacent to the one main part, optionally wherein each of the plurality of main parts have a same shape and size as each other in the plan view.

10. The panel substrate of any one of claims 1 to 9, wherein:
(i) a number of the plurality of bridge patterns disposed in a central region of the protective layer is greater than a number of the plurality of bridge patterns disposed in an outer region of the protective layer that surrounds the central region; and/or
(ii) the plurality of main parts have a different thickness in a vertical direction than a thickness of the plurality of bridge patterns in the vertical direction; and/or
(iii) each bridge pattern of the plurality of bridge patterns extends from a respective main part of the plurality of main parts.

11. A method of manufacturing a display module, the method comprising:
providing a mother substrate including a plurality of cell regions and a peripheral region surrounding the plurality of cell regions;
forming a protective layer on the mother substrate to form a panel substrate; and
cutting the panel substrate to form the display module,
wherein the protective layer includes:
a plurality of main parts overlapping the plurality of cell regions, and
a plurality of bridge patterns overlapping the peripheral region, the plurality of bridge patterns connecting main parts adjacent to each other among the plurality of main parts.

12. The method of claim 11, wherein the forming of the protective layer comprises:
applying a resin composition onto a top surface of the mother substrate to form a preliminary protective layer; and
curing the preliminary protective layer, optionally wherein in the forming of the preliminary protective layer, the applying of the resin composition is performed through a screen printing process or a slit coating process.

13. The method of claim 11 or claim 12, wherein:
(i) the cutting of the panel substrate comprises:
performing a first cutting that cuts the panel substrate along a first cutting line overlapping the peripheral region to form a plurality of sub-panel substrates; and
performing a second cutting that cuts the plurality of sub-panel substrates along a second cutting line corresponding to the plurality of cell regions; and/or
(ii) the method further comprises transferring the panel substrate, after the forming of the panel substrate; and/or
(iii) the mother substrate comprises:
a preliminary base layer;
a preliminary circuit layer disposed on the preliminary base layer; and
a preliminary light-emitting element layer disposed on the preliminary circuit layer.

14. A method of manufacturing a display module, the method comprising:
providing a mother substrate;
forming a protective layer directly on the mother substrate to form a panel substrate, the protective layer including a plurality of main parts, and a plurality of bridge patterns connecting main parts adjacent to each other among the plurality of main parts;
transferring the panel substrate, wherein the plurality of bridge patterns increases a tensile force in a central region of the mother substrate during the transferring of the panel substrate to reduce sagging of the mother substrate; and
cutting the panel substrate to form the display module after the transferring of the panel substrate.

15. The method of claim 14, wherein:
(i) the protective layer is provided in a single-layer form and is composed of a cured resin composition; and/or
(ii) at least some of the plurality of bridge patterns have shapes that are different from each other in a plan view,
wherein the shapes of the plurality of bridge patterns include at least two of a line shape, an X-shape, a zigzag shape or an L-shape in the plan view; and/or
(iii) a number of the plurality of bridge patterns disposed in the central region of the protective layer is greater than a number of the plurality of bridge patterns disposed in an outer region of the protective layer that surrounds the central region.
